## Europäisches Patentamt

## European Patent Office

## Office européen des brevets

(11) Veröffentlichungsnummer: **0 062 097 B1**

(12) **EUROPÄISCHE PATENTSCHRIFT**

(51) Int. Cl.⁴: **G 01 R 31/28**

(45) Veröffentlichungstag der Patentschrift:
02.05.85

(21) Anmeldenummer: 81108595.0

(22) Anmeldetag: 20.10.81

(54) Verfahren zur Darstellung logischer Zustandsänderungen mehrerer benachbarter Schaltungsknoten in integrierten Schaltungen in einem Logikbild mittels einer gepulsten Elektronensonde.

(30) Priorität: 16.03.81 DE 3110138

(43) Veröffentlichungstag der Anmeldung:
13.10.82 Patentblatt 82/41

(45) Bekanntmachung des Hinweises auf die Patenterteilung:
02.05.85 Patentblatt 85/18

(84) Benannte Vertragsstaaten:
DE FR GB NL

(56) Entgegenhaltungen:
DE - A - 2 813 948
DE - A - 2 814 049

TECHNISCHES MESSEN, Band 48, Nr. 1, 1981 P. FAZEKAS "Elektronenstrahl prüft elektrische Potentiale in integrierten Schaltungen" Seiten 29 bis 35
Beitr. elektronenmikroskop. Direkt-abb. Oberfl. 11 (1978) S. 67-71
Digest of papers 1980 IEEE Test Conference S. 444-449
SEM (1976) S. 615-624
J. Phys. E: Sci.Instr. vol. 10(1977) S. 911-913
SEM (1978) S. 375-380
Beitr. elektronenmikroskop. Direkt-abb. Oberfl. 8 (1975) S. 469-480

Die Akte enthält technische Angaben, die nach dem

(73) Patentinhaber: Siemens Aktiengesellschaft, Berlin und München Wittelsbacherplatz 2, D-8000 München 2 (DE)

(72) Erfinder: Fazekas, Peter, Dipl.-Ing., Stuntzstrasse 21, D-8000 München 80 (DE)
Erfinder: Feuerbaum, Hans-Peter, Dr., Tucholskystrasse 22, D-8000 München 83 (DE)
Erfinder: Knauer, Ulrich, Dipl.-Phys., Pfeuferstrasse 30, D-8000 München 70 (DE)
Erfinder: Otto, Johann, Ing.grad., Peter-Hammerschmid-Strasse 4, D-8170 Bad Tölz (DE)

(56) Entgegenhaltungen: (Fortsetzung)
Eingang der Anmeldung eingereicht wurden und die nicht in dieser Patentschrift enthalten sind.

ACTORUM AG

## Beschreibung

Die Erfindung betrifft ein Verfahren zur Darstellung der an benachbarten Schaltungsknoten einer programmgesteuerten integrierten Schaltung auftretenden logischen Zustände in einem zweidimensionalen Logikbild nach dem Oberbegriff des Anspruchs 1.

Für die Schaltungsanalyse während der Entwicklungsphase von Mikroprozessoren und Mikrocomputern mit immer grösser werdenden Datenbreiten ist eine neue Messtechnik erforderlich. Die Erfindung beschreibt ein Verfahren, mit dem eine Abbildung logischer Zustandsänderungen an benachbarten Leitbahnen möglich ist, sofern die interessierenden Messpunkte auf einer Geraden liegen.

Bekannt sind die miteinander verwandten Verfahren «Stroboscopic Voltage Coding» [H. P. Feuerbaum, «Beiträge zu Fortschritten in der Elektronenstrahl-Messtechnik, Beiträge elektronenmikroskopischer Direktabbildung Oberflächen 11», 67–71 (1978)] und «Logic State Mapping» [G. Crichton et al: Electron Beam Testing of Microprocessors, Digest of Papers 1980, IEEE Test Conference, pp. 444–449 (1980) und P. Fazekas in «Elektronenstrahl prüft elektrische Potentiale in integrierten Schaltungen», Technisches Messen, 48 (1981), 1, S. 29–35]. Diese bekannten Verfahren ermöglichen eine Abbildung logischer Zustandsänderungen an längeren parallel verlaufenden Leitbahnen gleichzeitig. An kurzen Leitbahnstücken sind die beiden genannten Verfahren jedoch nicht anwendbar.

Zustandsänderungen an kurzen Leitbahnen können entweder mit mechanischen Messspitzen oder mit der Elektronensonde Leitbahn für Leitbahn einzeln gemessen werden. Eine gleichzeitige Messung von Zustandsänderungen an kurzen Leitbahnen ist jedoch mit mechanischen Messspitzen schwer möglich.

Der Erfindung liegt die Aufgabe zugrunde, ein Verfahren zur Darstellung logischer Zustände mehrerer benachbarter Schaltungsknoten in integrierten Schaltungen in einem Logikbild mittels einer gepulsten Elektronensonde in einem Raster-Elektronenmikroskop anzugeben, welches auch an kurzen Leitbahnstücken anwendbar ist.

Diese Aufgabe wird erfindungsgemäss durch ein Verfahren nach dem Anspruch 1 gelöst.

Um den im Logikbild abzubildenden Zeitbereich zu bestimmen, wird der Phasenbereich eines Bilddurchlaufs frei gewählt.

Um eine Zuordnung zwischen Logikbild und Prüfling zu erhalten, ist es möglich, dass die Schaltung bis zur Abtastzeile elektronenmikroskopisch abgebildet wird, und dass erst bei Erreichen dieser Abtastzeile die Zeilenfortschaltung der gepulsten Elektronensonde unterbrochen wird. Das Bild auf dem Bildschirm des Raster-Elektronenmikroskops zeigt dann im oberen Teil einen Ausschnitt der integrierten Schaltung und im daran anschliessenden unteren Teil des Bildschirmes des Raster-Elektronenmikroskops eine Balkendarstellung der logischen Zustände der zuletzt abgebildeten Zeile dieser integrierten Schaltung, welche bei der Darstellung logischer Zustandsänderungen mehrerer benachbarter Schaltungsknoten in dieser integrierten Schaltung in einem Logikbild mittels einer gepulsten Elektronensonde als Aufnahmelinie dient.

Der Informationsgehalt der in einem Logikbild dargestellten logischen Zustandsänderungen mehrerer benachbarter Schaltungsknoten in integrierten Schaltungen entspricht dem eines konventionellen Logikanalysators, wie er zur Prüfung von Mikrocomputern und Rechnern verwendet wird [J. McLeod, Logic analyzers – sharp faultfinders getting sharper, Electronic Design, 28 (1980) 7, S. 48–56].

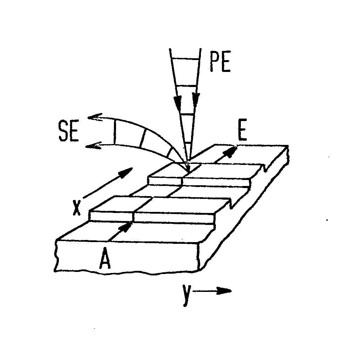

Die Erfindung ist in der Zeichnung dargestellt und wird im folgenden näher beschrieben.

Die Figur zeigt die Bewegung der gepulsten Elektrodensonde bei der Erzeugung des Logikbildes.

Die hier beschriebene Technik des Logikbildes baut auf den zum Stand der Technik zitierten Arbeiten auf. Im folgenden wird das Messprinzip zur Erstellung eines Logikbildes beschrieben. Die experimentellen Untersuchungen wurden an einem unpassivierten 8085 Mikroprozessor durchgeführt, der in einer geschrumpften Version bei Siemens entwickelt und hergestellt wurde.

Das Messprinzip zur Erstellung eines Logikbildes beruht auf dem Samplingprinzip (L. Balk et al., «Quantitative Voltage Contrast at High Frequencies in the SEM», SEM/1976 pp. 615–624). Das bedeutet in der Elektronenstrahlmesstechnik, dass die Elektronensonde mit der Frequenz der Programmschleife gepulst, und die Phase über die gesamte Schleife oder Teile davon geschoben wird. Die Programmschleifen sollen dabei so kurz wie möglich sein, da das Puls-Pauseverhältnis bei den Samplingtechniken mit der Elektronensonde nicht zu klein sein darf [A. Gopinath, «Estimate of minimum measurable voltage in the SEM», J. Phys. E: Sci. instrum., Vol. 10, pp. 911–913 (1977)].

In der Figur ist schematisch gezeigt, wie ein Logikbild entsteht. Die gepulste Elektronensonde tastet die Leitbahnen langsam in x-Richtung ab, von denen im Bild nur zwei gezeigt sind. Ist sie am Zeilenende E angelangt, springt sie zum Zeilenanfang A zurück und der Vorgang beginnt von neuem («line scan»).

Während die gepulste Elektronensonde auf der integrierten Schaltung stets dieselbe Strecke in x-Richtung abtastet, rastert der Elektronenstrahl am Bildschirm des Raster-Elektronenmikroskops diesen Bildschirm Zeile für Zeile ab, so dass ein flächenhaftes Bild auf diesem Bildschirm entsteht. Gleichzeitig mit dem Zeilenvorschub in y-Richtung am Bildschirm wird die Phase der Elektronenpulse, welche die Leitbahnen langsam in x-Richtung abtasten, kontinuierlich verschoben. Durch den frei wählbaren Phasenbereich während eines Bilddurchlaufes können entweder die gesamte Programmschleife oder beliebige Teile davon im Logikbild dargestellt werden. Die Abbildung der logischen Zustände erfolgt dabei durch den Potentialkontrast: logisch «0» erscheint hell und logisch «1» erscheint dunkel (A. Gopinath et al, «Voltage Contrast: A Review», SEM/1978 pp. 375–380 und H.-P. Feuerbaum et al., «Qualitative and quantitative voltage measurement on integrated circuits», Beiträge elektronenmikroskopischer Direktabbildung Oberfläche, vol. 8 pp. 469–480, 1975).

Die Messung mit einem erfindungsgemässen Verfahren an einem unpassivierten 8085 Mikroprozessor gibt die eingegebene Programmschleife exakt wieder.

Die Bedeutung des Logikanalysators für die Prüfung von Rechnersystemen mit grosser Datenbreite ist unbestritten. Nun ist es auch innerhalb integrierter Schaltungen möglich, sogar an kurzen Leitbahnstücken Logikbilder mit Hilfe einer gepulsten Elektronensonde zu erhalten. Schwächen und Fehler in Mikroprozessoren und Mikrocomputern, die mit anderen Mitteln nicht zu erfassen waren, konnten bereits erfolgreich aufgeklärt werden. Mit PE ist die gepulste Elektronensonde und mit SE sind die Sekundärelektroden bezeichnet.

**Patentansprüche**

1. Verfahren zur Darstellung der an benachbarten Schaltungsknoten einer programmgesteuerten integrierten Schaltung während der zyklisch wiederholten Abarbeitung einer Prògrammschleife zu bestimmten Zeitpunkten jeweils auftretenden logischen Zustände in einem zweidimensionalen Logikbild, bei dem die zu den betreffenden Schaltungsknoten führenden Leiterbahnen entlang eines dieser Leiterbahnen kreuzenden Abtastweges mit einem mit der Wiederholfrequenz der Programmschleife gepulsten Elektronenstrahl in einem Raster-Elektronenmikroskop abgetastet werden, wobei die Phase der Elektronenpulse kontinuierlich über die Programmschleife oder einen Teil derselben verschoben wird, und bei dem das sich bei der Abtastung ergebende Sekundärelektronensignal auf einem Bildschirm mit Zeilenraster dargestellt wird, dadurch gekennzeichnet, dass der Abtastweg eine einzige Abtastzeile umfasst, die wiederholt vom Elektronenstrahl durchlaufen wird, und dass die in aufeinanderfolgenden Durchläufen dieser Abtastzeile erhaltenen Sekundärelektronensignale jeweils in aufeinanderfolgenden Zeilen des Bildschirmes wiedergegeben werden.

2. Verfahren nach Anspruch 1, dadurch gekennzeichnet, dass der Phasenbereich entsprechend dem im Logikbild abzubildenden Zeitbereich gewählt wird.

3. Verfahren nach Anspruch 1 oder 2, dadurch gekennzeichnet, dass die Schaltung bis zur Abtastzeile elektronenmikroskopisch abgebildet wird und erst bei Erreichen dieser Abtastzeile die Zeilenfortschaltung der gepulsten Elektronensonde unterbrochen wird.

**Claims**

1. A method of representing in a two-dimensional logic display the logic states which occur at respective specific times at adjacent circuit nodes of a programme controlled integrated circuit during cyclical repetitive processing of a programme loop, wherein the conductor paths which lead to the relevant circuit nodes are scanned along a scanning path which intersects these conductor paths by an electron beam which is pulsed at the repetition frequency of the programme loop in a scanning electron microscope, where the phase of the electron pulses is continuously displaced over the programme loop or part thereof, and where the secondary electron signal produced during scanning is represented on a screen with a line raster pattern, characterised in that the scanning path covers one single scanning line which is repeatedly swept over by the electron beam; and the secondary electron signals obtained in consecutive sweeps of this scanning line are each reproduced in consecutive lines of the screen.

2. A method as claimed in claim 1, characterised in that the phase range is selected in accordance with the time range which is to be portrayed in the logic display.

3. A method as claimed in claim 1 or 2, characterised in that the circuit is portrayed electron-microscopically up to the scanning line and not until this scanning line has been reached is the line feed of the pulsed electron probe interrupted.

**Revendications**

1. Procédé pour représenter les états logiques qui se présentent respectivement, et à des instants déterminés, au niveau de nœuds contigus de circuits d'un circuit intégré commandé par programme pendant le traitement répété cycliquement d'une boucle de programme, dans un schéma logique bidimensionnel, dans lequel les pistes conductrices menant aux nœuds concernés du circuit sont balayées, dans un microscope électronique à balayage, à l'aide d'un rayon électronique pulsé à la fréquence de répétition de la boucle de programme, de long d'une voie de balayage intersectant ces pistes conductrices, la phase des impulsions des électrons étant décalée de façon continue durant la boucle de programme ou durant une partie de celle-ci, et dans lequel le signal formé par les électrons secondaires, qui résulte du balayage, est représenté sur un écran avec une trame de ligne, caractérisé par le fait que la voie de balayage comporte une seule ligne de balayage qui est traversée de façon répétitive par le rayon électronique, et que les signaux des électrons secondaires obtenus par les passages successifs sur cette ligne de balayage, sont respectivement représentés sur l'écran suivant des lignes successives.

2. Procédé selon la revendication 1, caractérisé par le fait que l'étendue de la phase est choisi en fonction de l'étendue du temps à reproduire dans le schéma logique.

3. Procédé selon la revendication 1 ou 2, caractérisé par le fait que le circuit est reproduit jusqu'à la ligne de balayage à l'aide d'un microscope électronique, alors que ce n'est que lorsque cette ligne de balayage est atteinte qu'est interrompu le passage de ligne à ligne de la sonde électronique pulsée.